(19) Europäisches Patentamt / European Patent Office / Office européen des brevets

(11) **EP 1 430 484 B1**

(12) **FASCICULE DE BREVET EUROPEEN**

(45) Date de publication et mention
de la délivrance du brevet:
**14.11.2007 Bulletin 2007/46**

(51) Int Cl.:
**G11C 11/16** *(2006.01)* **H01F 10/32** *(2006.01)*
**H01F 10/12** *(2006.01)*

(21) Numéro de dépôt: **02798773.4**

(22) Date de dépôt: **19.09.2002**

(86) Numéro de dépôt international:
**PCT/FR2002/003210**

(87) Numéro de publication internationale:
**WO 2003/025942 (27.03.2003 Gazette 2003/13)**

(54) **MEMOIRE MAGNETIQUE A ECRITURE PAR COURANT POLARISE EN SPIN, METTANT EN OEUVRE DES ALLIAGES AMORPHES FERRIMAGNETIQUES ET PROCEDE POUR SON ECRITURE**

MAGNETISCHE SPEICHERANORDNUNG BESCHREIBBAR DURCH SPIN-POLARISIERTEN STROM UNTER BENÜTZUNG VON AMORPHEN FERRIMAGNETISCHEN LEGIERUNGEN, UND SCHREIBVERFAHREN IN DIESER SPEICHERANORDNUNG

MAGNETIC MEMORY WITH SPIN-POLARIZED CURRENT WRITING, USING AMORPHOUS FERROMAGNETIC ALLOYS, WRITING METHOD FOR SAME

(84) Etats contractants désignés:
**AT BE BG CH CY CZ DE DK EE ES FI FR GB GR IE IT LI LU MC NL PT SE SK TR**

(30) Priorité: **20.09.2001 FR 0112124**

(43) Date de publication de la demande:
**23.06.2004 Bulletin 2004/26**

(73) Titulaire: **CENTRE NATIONAL DE LA RECHERCHE SCIENTIFIQUE (CNRS)**
**75794 Paris Cedex 16 (FR)**

(72) Inventeurs:
• **NOZIERES, Jean-Pierre**
  **F-38700 CORENC (FR)**
• **RANNO, Laurent**
  **F-38000 GRENOBLE (FR)**
• **CONRAUX, Yann**
  **F-38000 GRENOBLE (FR)**

(74) Mandataire: **de Beaumont, Michel**
  **Cabinet Michel de Beaumont**
  **1, rue Champollion**
  **38000 Grenoble (FR)**

(56) Documents cités:
**EP-A- 1 115 164        GB-A- 2 343 308**
**US-A- 5 695 864**

• **KUO P C ET AL: "MAGNETIC PROPERTIES AND MICROSTRUCTURE OF AMORPHOUS CO100-XTBX THINFILMS" JOURNAL OF APPLIED PHYSICS, AMERICAN INSTITUTE OF PHYSICS. NEW YORK, US, vol. 84, no. 6, 15 septembre 1998 (1998-09-15), pages 3317-3321, XP000786541 ISSN: 0021-8979**

EP 1 430 484 B1

## Description

## Domaine technique

La présente invention se rattache au domaine des mémoires magnétiques, et notamment des mémoires magnétiques à accès aléatoire non volatiles permettant le stockage et la lecture de données dans les systèmes électroniques. Plus précisément, elle concerne les mémoires à accès aléatoire magnétiques, appelées M-RAM, constituées d'une jonction tunnel magnétique.

## Etat Antérieur de la technique

Les mémoires basées sur l'état de charge d'une capacité (DRAM, SRAM, FLASH) deviennent de plus en plus sensibles aux radiations ionisantes (telles que par exemple les rayons cosmiques) au fur et à mesure que la dimension des transistors élémentaires se réduit. Par ailleurs, les mémoires à base de ferroélectriques (FRAM) présentent de sérieux problèmes de vieillissement. Les développements récents dans le domaine de la magnéto-électronique ont permis de concevoir un nouveau type de mémoire, basé sur la magnétorésistance de jonctions magnétiques. En d'autres termes, leur principe de fonctionnement ne repose plus sur le stockage d'une charge électrique, mais sur l'orientation relative de l'aimantation des éléments qui la constituent. Ces mémoires magnétiques à accès aléatoire (Magnetic Random Access Memories - MRAM) présentent de nombreux atouts : rapidité (quelques nanosecondes de durée d'écriture et de lecture), non volatilité, absence de fatigue à la lecture et à l'écriture, insensibilité aux radiations ionisantes. Elles sont susceptibles dans un premier temps, de remplacer les mémoires flash et, à plus long terme, les DRAM et SRAM pour devenir une mémoire universelle.

Dans les premières mémoires magnétiques, le point mémoire était constitué d'un élément dit à magnétorésistance géante, formé d'un empilement de plusieurs couches métalliques alternativement magnétiques et non magnétiques. Une description détaillée de ce type de structures peut être trouvée dans les documents US-A-4 949 039 et US-A-5 159 513 pour les structures de base, et dans le document US-A-5 343 422 pour la réalisation d'une mémoire RAM à partir de ces structures de base. Ce type de mémoire, de part son architecture, permet la réalisation de mémoires non volatiles avec une technologie simple, mais de capacité limitée. En effet, le fait que les éléments mémoire soient connectés en série le long de chaque ligne limite la possibilité d'intégration, puisque le signal est de plus en plus faible lorsque le nombre d'éléments augmente.

Les structures les plus prometteuses utilisent pour chaque point mémoire une jonction tunnel magnétique, appelée par la suite Magnetic Tunnel Junction - MTJ, et composées dans leur forme la plus simple, de deux couches magnétiques de coercitivités différentes, séparées par une mince couche isolante. Une description de ces structures est donnée dans la publication Physics Letters volume 54A (1975) page 225, ou plus récemment dans les publications Journal of Magnetism and Magnetic Materials volume 139 (1995) page L139 et Physical Review Letters volume 74 (1995) page 3273. L'utilisation de ces structures pour la fabrication de MRAM a été décrite initialement dans le document US-A-5 640 343.

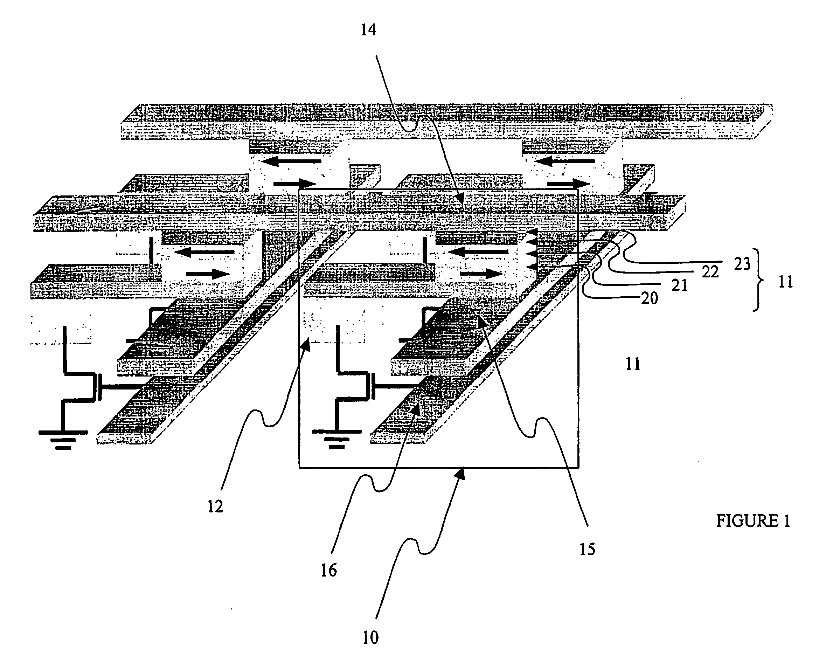

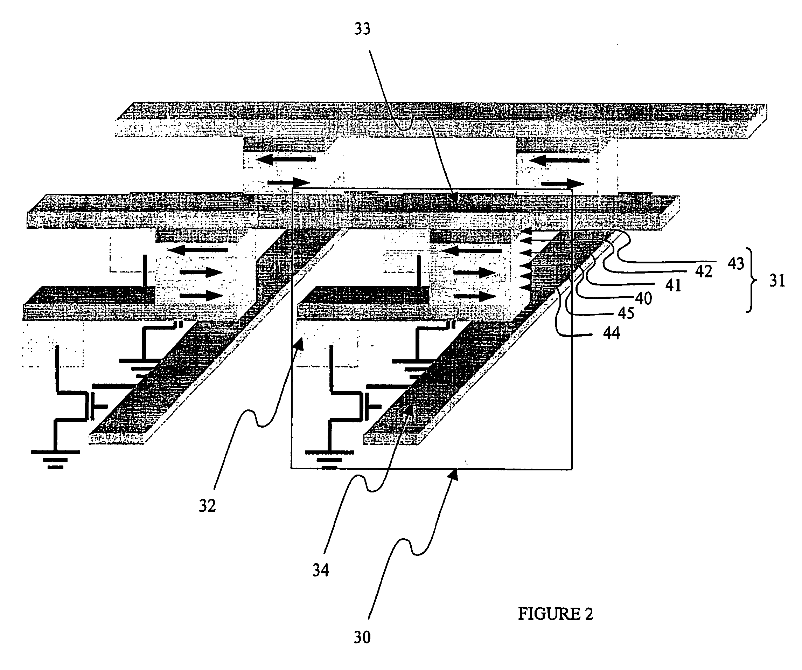

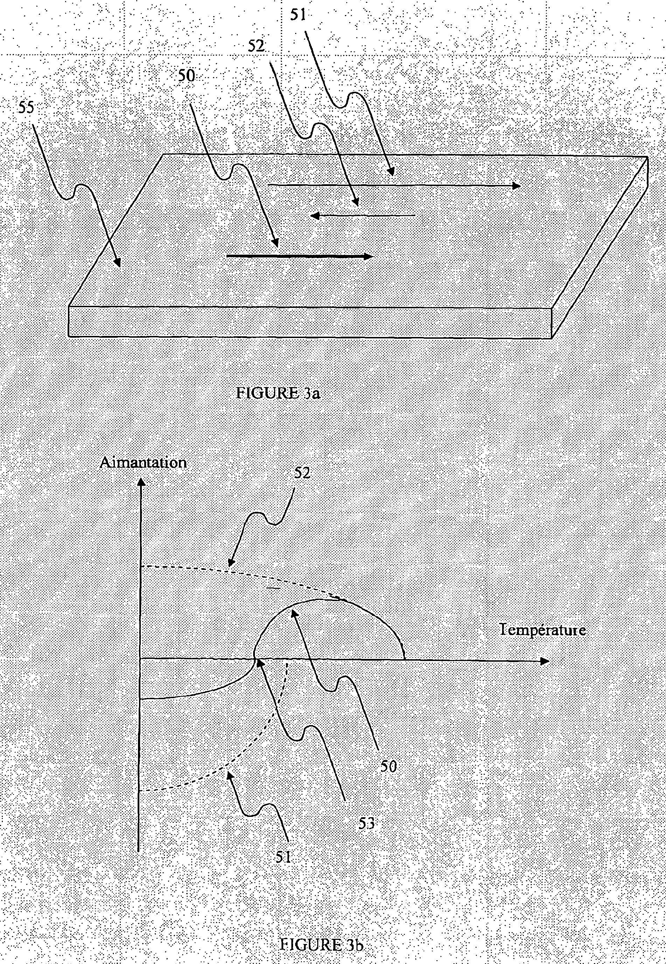

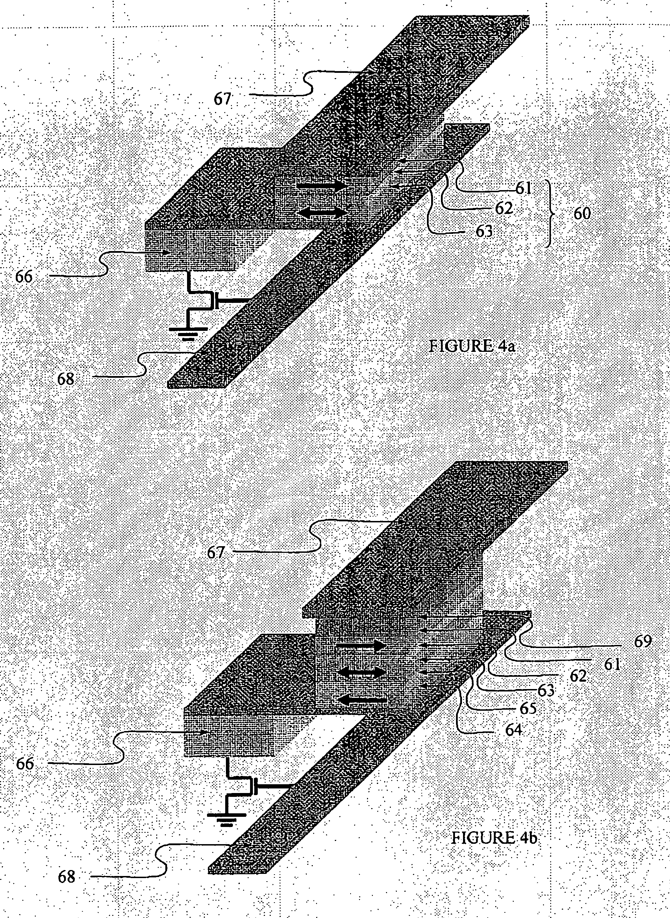

L'architecture la plus prometteuse pour l'instant semble être celle décrite dans le document US-A-6 021 065 et dans la publication Journal of Applied Physics volume 81 (1997) page 3758, et dont le principe est représenté schématiquement sur la figure 1. Comme on peut le voir sur la figure 1, chaque élément ou point mémoire (10) est constitué de l'association d'un transistor CMOS (12) et d'une jonction MTJ (11). La dite jonction (11) comporte au moins une couche magnétique (20), dite couche libre, une fine couche isolante (21) et une couche magnétique (22), dite couche piégée. Préférentiellement mais de manière non limitative, les deux couches magnétiques sont réalisées à base des métaux 3d (Fe, Co, Ni) et leurs alliages, et la couche isolante est constituée d'alumine ($Al_2O_3$). Préférentiellement, la couche magnétique (22) est couplée à une couche antiferromagnétique (23), dont la fonction est de piéger la couche (22), afin que son aimantation ne bascule pas lors de l'écriture. Préférentiellement aussi, la couche (22) peut être elle-même formée de plusieurs couches, ainsi que le décrit par exemple le document US-A-5 583 725 pour former une couche dite anitferromagnétique synthétique. Toutes ces variantes, ainsi que d'autres, sont bien connues de l'homme de métier.

L'architecture comporte en outre trois niveaux de lignes. Les deux niveaux de lignes (14) (word line) et (15) (bit line), généralement disposés à 90° l'un par rapport à l'autre, sont destinés à acheminer des impulsions électriques propres à créer un champ magnétique permettant la commutation de l'aimantation de la couche (20) lors du processus d'écriture. Ces impulsions de champ sont produites en envoyant des impulsions de courant courtes (typiquement 2 à 5 nanosecondes) et d'intensité de l'ordre de 10 mA le long des lignes (14) et (15). L'intensité de ces impulsions et leur synchronisation sont ajustées de sorte que seule l'aimantation du point mémoire se trouvant à la croisée de ces deux lignes peut commuter. Un niveau de ligne additionnel (16) (control line) est destiné à commander l'ouverture ou la fermeture du canal des transistors (12) pour pouvoir adresser chaque élément mémoire individuellement lors de la lecture. Les transistors (12) sont utilisés comme des interrupteurs.

En mode écriture, le transistor (12) sélectionné est en mode bloqué ou OFF, aucun courant ne le traverse. On envoie une impulsion de courant I dans les deux lignes (14) et (15) correspondant au point mémoire (10) sélectionné. L'amplitude de l'impulsion de courant I est telle que le champ magnétique créé ne soit pas suffisant pour faire basculer les points mémoire sur les lignes (14) ou (15), sauf à l'intersection des dites lignes (14) et (15), où la contribution conjointe des deux lignes est suffisante pour faire basculer l'aimantation de la couche (20) du point mémoire.

En mode lecture, le transistor (12) est en mode saturé ou ON par l'envoi d'une impulsion de courant positive dans sa base à travers la ligne de commande (16), le courant qui le traverse est maximum. Un courant de mesure est ensuite envoyé dans la ligne (14), qui ne peut traverser que le seul point mémoire dont le transistor (12) est en position ON. Par ce courant, on effectue une mesure de la résistance de la jonction (11) du point mémoire (10) sélectionné. Par comparaison avec un point mémoire référence qui n'est pas décrit ici, l'état correspondant du point mémoire (10) (1 ou 0) est ainsi déterminé.

En décrivant le mécanisme d'écriture de ces points mémoire, on comprend clairement les limites de cette architecture :

• L'écriture étant assurée par un champ magnétique extérieur, elle est assujettie à la valeur du champ de retournement individuel de chaque point mémoire. Si la fonction de distribution des champs de retournement pour l'ensemble des points mémoire est large (en effet, elle n'est pas uniforme en raison des contraintes de fabrication), il est nécessaire que le champ magnétique sur le point mémoire sélectionné soit supérieur au champ de retournement le plus élevé de la dite fonction de distribution, au risque de renverser accidentellement certains points mémoire situés sur la ligne et ou la colonne correspondante, dont le champ de retournement, situé dans la partie basse de la distribution, est plus faible que le champ magnétique généré par la ligne ou la colonne seule. Inversement, si l'on souhaite s'assurer qu'aucun point mémoire ne soit écrit par une ligne ou une colonne seule, il faut limiter le courant d'écriture de façon à ne jamais dépasser pour ces points mémoire le champ magnétique correspondant à la partie basse de la distribution, au risque de ne pas écrire le point mémoire sélectionné à l'intersection desdites lignes et colonnes, si son champ de retournement est dans la partie haute de la distribution. En d'autres termes, cette architecture à sélection par champ magnétique à l'aide de lignes et de colonnes de conducteurs peut facilement conduire à des erreurs d'adressage à l'écriture. Compte tenu de ce qu'il est attendu que la fonction de distribution des champs de retournement des points mémoire soit d'autant plus large que leur dimension est faible, puisque c'est la géométrie des points mémoire (forme, irrégularités, défauts) qui domine le renversement de l'aimantation, cet effet ne pourra qu'empirer dans les générations de produits futurs.

• Etant entendu qu'en général la valeur moyenne du champ de retournement augmente lorsque la taille des points mémoire diminue, un courant d'autant plus important est attendu dans les générations de produits futures. En conséquence, la puissance électrique requise pour le fonctionnement de ces mémoires sera d'autant plus grande que l'intégration sera poussée.

• Le mode d'écriture par deux lignes de courant orientées à 90° décrit ci-dessus nécessite trois niveaux de lignes. En particulier la ligne de commande du transistor doit être décalée de la ligne de courant inférieure (requise pour l'écriture), ce qui minimise les possibilités d'intégration.

• Enfin, ce mode d'écriture ne permet d'écrire qu'un seul point mémoire à la fois pour minimiser le risque d'erreur d'adressage.

Une alternative à cette architecture a été proposée. Elle consiste à adresser à l'écriture les points mémoire non plus par un champ magnétique extérieur, mais par un courant électrique polarisé en spin. En effet, il a été prédit dans la publication Journal of Magnetism and Magnetic Materials volume 159 (1996) page L1, qu'un courant polarisé en spin était capable de provoquer une précession, voire un renversement de l'aimantation par transfert du moment angulaire de spin entre les porteurs polarisés et le moment magnétique du système. Plus récemment, cet effet a été démontré expérimentalement dans des structures entièrement métalliques de taille réduite (<100 nm), comme décrit dans la publication Science volume 285 (1999) page 867. Enfin, l'utilisation de cette technique pour les mémoires magnétiques a été décrite dans le document US-A-5 695 864. Comme on peut le voir sur la figure 2, dans cette architecture, le point mémoire (30) comporte une jonction MTJ (31) et un transistor CMOS (32), mais il n'y a plus que deux niveaux de ligne (33) et (34), la ligne (33) correspondant à l'amenée de courant pour la lecture et l'écriture, et la ligne (34) à la commande du transistor qui permet d'adresser chaque point mémoire (30) individuellement. Les transistors (32) sont utilisés comme des interrupteurs.

La MTJ (31) est formée, comme dans l'état antérieur de la technique décrit précédemment, d'une couche magnétique (40), dite couche libre, d'une fine couche isolante (41) et une couche magnétique (42), dite couche piégée, et d'une couche antiferromagnétique (43), dont la fonction est de piéger l'aimantation de la couche (42) dans une direction fixe. Avantageusement, une couche magnétique additionnelle (44) de polarisation du courant d'écriture peut être rajoutée du coté couche magnétique (40), séparée de cette dernière par une couche non magnétique de faible résistivité (45).

En mode lecture, le système fonctionne comme dans l'état antérieur de la technique, à savoir que le transistor (32) correspondant au point mémoire (30) à adresser est en mode saturé ou ON par l'envoi d'une impulsion de courant positive dans la base à travers la ligne de commande (34). Un courant de mesure de faible intensité est ensuite envoyé dans la ligne (33), qui ne peut traverser que le seul point mémoire dont le transistor (34) est en position ON. Par ce courant, on effectue une mesure de la résistance de la jonction (31) du point mémoire (30) sélectionné. Par comparaison avec un point mémoire référence qui n'est pas décrit ici, l'état correspondant du point mémoire (30) (1 ou 0) est ainsi déterminé.

En mode écriture le fonctionnement est radicalement différent de l'état antérieur de la technique décrit précédemment. Le transistor (32) sélectionné est en mode saturé ou ON par l'envoi d'une impulsion de courant dans la ligne (34). Un courant d'écriture de forte intensité est envoyé par la ligne (33), de façon à ne traverser que le point mémoire (30) sélectionné. Le courant d'écriture est polarisé au passage de la couche magnétique (42) (ou (44)) selon le sens de passage du courant de sorte que les spins des électrons pénétrant la couche magnétique (40) sont majoritairement orientés dans la direction de l'aimantation de la couche (42) (ou (44)). Lorsque l'amplitude de ce courant fortement polarisé en spin est suffisante, l'aimantation de la couche magnétique (40) est renversée. L'écriture par courant polarisé en spin étant, par nature, limitée à un point mémoire, puisque seul le point mémoire dont le transistor est en mode saturé ou « ON » est traversé par le courant d'écriture, les erreurs d'adressage sont intrinsèquement impossibles. Ce mode d'écriture est donc bien plus reproductible que le procédé décrit dans l'état antérieur de la technique. Autre avantage de cette technique, d'après les modèles théoriques en vigueur à ce jour la densité de courant nécessaire au renversement de l'aimantation du point mémoire n'est plus assujettie au champ de retournement (Hc), propriété extrinsèque du matériau, donc dépendant de sa géométrie et de la présence éventuelle de défauts, mais à l'anisotropie magnétique (Hk) du point mémoire, propriété intrinsèque du matériau donc a priori beaucoup plus facilement contrôlable. En particulier, elle est indépendante de la taille et de la forme du point mémoire, donc la densité de courant critique reste constante quand la taille du point mémoire décroît, comme attendu dans les générations de produit futures, contrairement à l'état antérieur de la technique utilisant un champ magnétique généré par des lignes de courant, où le courant nécessaire à l'écriture, donc la consommation, augmente avec la diminution de la taille du point mémoire. Enfin, il est possible d'écrire plusieurs points mémoire à la fois, ce qui facilite la vitesse de transfert de données.

Malheureusement, cette architecture possède encore à ce jour une sérieuse limitation. En effet, le renversement d'aimantation par injection de courant polarisé nécessite des densités de courant importantes, ce qui n'est pas un problème pour des structures entièrement métalliques, hormis une consommation électrique importante, mais qui conduit dans des structures tunnel de type MTJ à des tensions aux bornes de la jonction qui sont supérieures aux tensions de claquage usuelles (1 V environ, selon l'épaisseur de la couche d'isolant (41)). La raison principale est donnée par la relation (1) issue de la publication Journal of Magnetism and Magnetic Materials 159 (1996) L1 qui exprime le courant critique en fonction des autres paramètres de la structure :

$$J_c = \frac{\alpha}{\eta} \frac{2e}{\hbar} t H_K M_s \left( 1 \pm \frac{2\pi M_s}{H_k} \right) \quad (1)$$

où $\alpha$ est le coefficient d'amortissement, $\eta$ est le facteur de polarisation de spin, t est l'épaisseur de couche magnétique, $H_k$ est le champ d'anisotropie magnétique uniaxiale et $M_s$ est l'aimantation de la couche magnétique. Dans cette formule le terme $2\pi M_s$, qui correspond au terme de champ démagnétisant de la couche magnétique (40), augmente considérablement la densité de courant requise pour observer le renversement d'aimantation. On peut comprendre son influence en considérant que lors du renversement de l'aimantation de la couche (40), celle-ci va précesser sur un cône autour de sa direction initiale et donc pour cela sortir du plan de la couche. Au champ de renversement, cette précession est telle que l'aimantation de la couche (40) est quasi perpendiculaire au plan des couches, ce qui est d'autant plus difficile que le champ démagnétisant est grand.

L'objet de la présente invention est précisément de diminuer fortement la densité de courant requise à l'écriture, de façon à éviter le claquage électrique et à minimiser la consommation électrique de la mémoire.

Le document EP-A-1115164 décrit un dispositif magnétorésistif comprenant deux couches magnétiques et une couche non-magnétique interposée entre les deux couches magnétiques, au moins l'une des couches magnétiques étant constituée d'un matériau ferrimagnétique.

Le document Kuo P.C. et al. : "Magnetic properties and microstructure of amorphous C0100-XTBX thinflims", de Journal of Applied Physics, American Institute of Physics, New York, U.S.A., volume 84, N°6, du 15 septembre 1998, pages 3317-3321, XP000786541 ISSN : 0021-8979, décrit des propriétés magnétiques de microstructure d'alliage amorphe, de terre rare et de métal de transition.

**Descriptif de l'invention**

L'invention propose une structure de type MTJ qui minimise le champ démagnétisant afin d'abaisser au maximum la densité de courant seuil requise pour l'écriture. Pour cela elle vise à remplacer les couches ferromagnétiques usuelles (20, 22) et (40, 42) comme décrit dans les figures 1 et 2, basées sur des métaux 3d (Fe, Co, Ni) et leurs alliages par des alliages amorphes à base de terres rares et de métaux de transition, appelés alliages amorphes ferrimagnétiques (AAF) par la suite.

L'invention propose un procédé selon les revendications 1-3 et une mémoire magnétique selon les revendications 4-15.

Elle propose donc une mémoire magnétique, dont chaque point mémoire est constitué d'une jonction tunnel magnétique, comprenant:

- une couche magnétique, dite couche piégée, dont l'aimantation est rigide,
- une couche magnétique, dite couche libre, dont l'aimantation peut être inversée,
- une couche isolante, interposée entre la couche libre et la couche piégée et au contact respectif de ces deux couches.

Selon l'invention, la couche libre est réalisée en un alliage amorphe ou nanocristallisé à base de terre rare et d'un métal de transition, l'ordre magnétique dudit alliage étant de type ferrimagnétique, ladite couche libre étant à aimantation sensiblement planaire.

Par aimantation planaire, on sous-tend que le moment magnétique est situé dans le plan de la couche considérée, ou sensiblement situé dans ce plan, un angle de 10 à 30° par rapport audit plan étant considéré comme englobé dans cette définition.

Selon l'invention, l'écriture des points mémoire est réalisée par l'injection d'un courant électrique par le biais d'un conducteur électrique placé sur chacun desdits points mémoire, les électrons dudit courant étant polarisé en spin par le biais de la couche piégée.

La manière dont l'invention peut être réalisé, et les avantages qui en découlent ressortiront mieux des exemples de réalisation qui suivent, donnés à titre indicatif et non limitatif à l'appui des figures annexées

**Description sommaire des figures**

La figure 1, déjà décrite, est une représentation schématique de l'architecture d'une mémoire magnétique de l'état antérieur de la technique, dont les points mémoire sont constitués par une MTJ.

La figure 2 est une représentation schématique analogue de la figure 1, d'une mémoire magnétique mettant en oeuvre l'écriture par courant polarisé de la présente invention.

La figure 3 a est une représentation schématique de l'aimantation d'un AAF.

La figure 3b est une courbe représentant la variation de l'aimantation d'un AAF en fonction de la température.

La figure 4a est une représentation schématique d'une mémoire magnétique conforme à une première forme de réalisation de l'invention.

La figure 4b est une représentation schématique d'une mémoire magnétique conforme à une seconde forme de réalisation de l'invention.

La figure 5 est une représentation schématique plus détaillée du point mémoire (60) de la figure 4a.

**Description détaillée de l'invention**

Ainsi que brièvement rappelé ci-dessus, le fonctionnement de la mémoire conforme à l'invention repose sur la mise en oeuvre de matériaux AAF et des propriétés spécifiques qui y sont associées. Il va donc être tout d'abord rapidement détaillé ces phénomènes. Ainsi qu'on peut l'observer sur la figure 3a, l'aimantation macroscopique (50) d'une couche (55) d'un AAF peut être décomposée en deux contributions, une contribution due au sous réseau des atomes de terre rare (51), et une contribution due au sous réseau des atomes de métal de transition (52). De façon schématique, l'aimantation macroscopique (50) résulte de la somme vectorielle des aimantations des deux sous réseaux (51) et (52).

Par ailleurs, les aimantations du sous réseau de terre rare (51) et du sous réseau du métal de transition (52) sont fortement couplées entre elles, résultant en un comportement conjoint lors du renversement de l'aimantation macroscopique (50) ou de la réorientation par une excitation sélective de l'un des sous réseaux (51) et (52).

En outre, lorsque la nature chimique et la composition relative de la terre rare et du métal de transition sont judicieusement choisies, l'ordre magnétique est de type ferrimagnétique, c'est à dire que l'aimantation du sous-réseau des atomes de terre rare (51) pointe dans une direction tandis que l'aimantation du sous réseau des atomes de métal de transition (52) pointe dans la direction opposée. Comme on peut le voir sur la figure 3a, si la valeur absolue des aimantations (51) et (52) des deux sous-réseaux n'est pas égale, le moment magnétique macroscopique (50) de l'ensemble de l'AAF est non nul.

Par ailleurs, comme on le voit sur la figure 3b, les variations en température des aimantations (51) du sous réseau de la terre rare, et (52) du métal de transition sont très différentes, conduisant à une variation avec la température de l'importance relative des contributions des deux sous réseaux à l'aimantation macroscopique résultante. En règle générale, l'aimantation du sous réseau de terre rare (51) décroît plus vite que l'aimantation du sous réseau de métal de transition (52). Lorsque la nature chimique et la composition relative de la terre rare et du métal de transition sont judicieusement choisies, pour que les aimantations (51) et (52) des deux sous-réseaux soient antiparallèles, il existe une température, appelée température de compensation (53), à laquelle ces deux aimantations sont parfaitement compensées, c'est à dire qu'elles sont égales en amplitude et opposées en signe, donc l'aimantation macroscopique (50) résultante est nulle. En dessous de la température de compensation, le sous réseau de terre rare (51) domine et définit la direction de l'aimantation macroscopique (50). Au-dessus de la température de compensation, le sous réseau de métal de transition (52) domine et détermine la direction de l'aimantation macroscopique (50).

Par ailleurs, à la température de compensation (53), le champ coercitif diverge et tend vers l'infini. De part et d'autre de la température de compensation, le champ coercitif décroît d'autant plus rapidement que la température est proche de la température de compensation (53).

Par ailleurs, les électrons contribuant à l'aimantation du sous réseau de métal de transition (52) sont principalement les électrons de conduction (électrons 3d), c'est à dire les électrons qui participent au transport du courant électrique. Par contre, les électrons responsables de l'aimantation du sous réseau de terre rare (51) sont les électrons des niveaux de coeur (électrons 4f), qui sont localisés et fortement écrantés par les autres électrons du système.

Enfin, les propriétés intrinsèques de ces AAF (aimantation macroscopique, anisotropie magnétique, champ coercitif) peuvent être très facilement contrôlées par la nature chimique des éléments mis en jeu et leurs concentrations respectives. On peut également pour cela rajouter des faibles quantités d'éléments de substitution, en général des métaux de transition, des métaux réfractaires ou des terres rares, comme par exemple mais de manière non limitative du Mo, Ta, Nb, Zr, Pt, Dy et Sm. Ces ajustements permettent en particulier d'obtenir des matériaux à aimantation planaire comme cela est requis pour la couche libre des structures décrites dans la présente invention.

Parmi les AAF envisagés dans la présente invention, on trouve de manière préférentielle mais non limitative l'alliage amorphe de Gadolinium (Gd) et de Cobalt (Co), par exemple mais de manière non limitative avec la composition $Gd_{30}Co_{70}$, qui associe un ordre ferrimagnétique, une faible anisotropie magnétocristalline, et lorsque la composition est judicieusement choisie une température de compensation proche de la température de fonctionnement de la mémoire.

Comme on peut le voir sur la figure 4a, le point mémoire de la mémoire conforme à l'invention est formé d'une MTJ (60) comportant au moins une couche magnétique (61), dont l'aimantation est piégée, une couche isolante (62), et une couche d'alliage AAF (63), dont on souhaite renverser l'aimantation pour écrire le point mémoire (60). Une ligne d'amenée de courant (67) est placée sur le point mémoire (60) et un transistor (66), commandé par la ligne de courant (68), est placé sous le point mémoire (60) comme dans l'état antérieur de la technique.

Avantageusement comme on peut le voir sur la figure 4b une couche antiferromagnétique (69) est placée sur la couche piégée (61) pour bloquer son aimantation.

En outre, comme on peut également l'observer sur la figure 4b, une couche magnétique de polarisation (64) additionnelle est placée sous la couche (63), dont elle est séparée par une couche métallique non magnétique (65), par exemple de l'or. Cette couche de polarisation additionnelle (64), par exemple réalisée à base d'un alliage de Terbium et de Cobalt, peut posséder une aimantation parallèle ou perpendiculaire au plan des couches constitutives de la MTJ (60). Cette couche est également destinée à assurer la polarisation en spin des impulsions de courant lors de l'écriture, lorsque celles-ci sont acheminées par la ligne de courant inférieure, notamment par le conducteur (68) relié au transistor (66).

Avantageusement la couche magnétique (61) peut être formée d'un alliage AAF, identique ou différent de la couche (63) dont le champ de retournement est grand, par exemple un alliage à base de Terbium et de Cobalt. La nature chimique des couches (64) et (65) importe peu dans le fonctionnement du système.

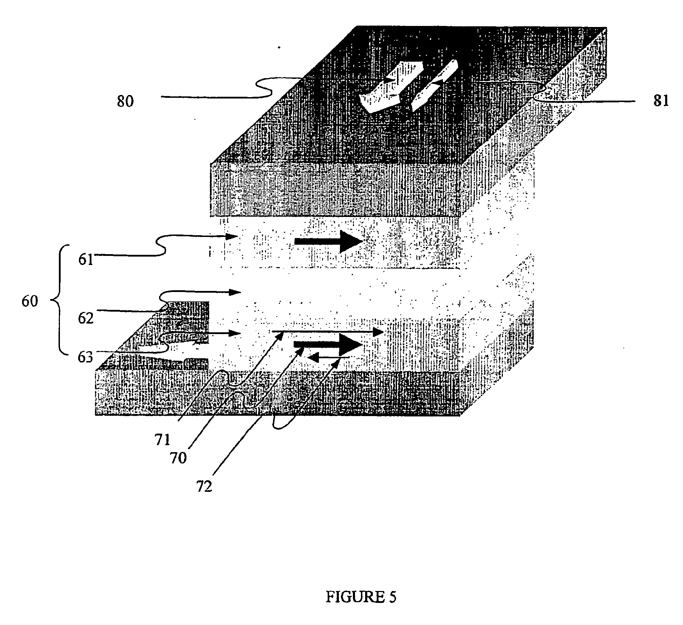

Le processus d'écriture peut être décrit de la façon suivante comme on peut le voir sur la figure 5 qui est une vue agrandie du point mémoire (60) de la figure 4a.

Un courant d'écriture (80) de forte amplitude est injecté dans la MTJ (60). En traversant la couche (61), le courant (80) est fortement polarisé en spin lorsqu'il pénètre dans la couche (63) dont on souhaite renverser l'aimantation. Compte tenu de la nature spécifique des propriétés électroniques de la couche (63) décrites précédemment, les électrons injectés par le courant d'écriture (80), fortement polarisés en spin, vont interagir principalement avec le sous réseau du métal de transition (72), résultant en un transfert du moment angulaire de spin entre les porteurs polarisés du courant injecté (80) et le moment magnétique des atomes dudit sous réseau de métal de transition (72). En raison de la nature fortement écrantée des électrons responsables du magnétisme dans le sous réseau des atomes de terre rare (71), l'interaction du courant d'écriture (80) avec lesdits électrons est très faible. En conséquence, le courant injecté (80) ne voit principalement qu'une seule direction de l'aimantation dans la couche (63), celle du sous réseau des atomes de transition (72), ce qui permet le renversement dudit sous réseau si les conditions nécessaires d'amplitude et de durée dudit courant (80) sont respectées. En raison du couplage important existant entre les sous réseaux (71) et (72), le sous réseau (71), bien que peu excité par le courant injecté (80), suit le sous réseau (72) ce qui permet le renversement complet de l'aimantation de la couche (63).

Il convient de préciser que l'aimantation de la couche de polarisation (64) peut être essentiellement dans le plan ou perpendiculaire au plan. Selon les modèles en vigueur, si l'aimantation est dans le plan, l'aimantation de la couche libre (63) va précesser autour de l'axe défini par la direction du spin des électrons injectés dans la couche libre, puis s'amortir parallèlement à cette direction. La durée de pulse de courant doit alors être suffisamment longue pour permettre à cette précession puis à cet amortissement de s'effectuer. Si l'aimantation de la couche de polarisation est perpendiculaire au plan, l'aimantation de la couche libre va alors précesser autour d'un axe perpendiculaire au plan des couches c'est à dire en restant dans le plan de ladite couche libre. Si l'on veut que l'aimantation de la couche libre commute dans son plan de 180°, il faut alors ajuster la durée du pulse de courant d'écriture pour que l'aimantation n'effectue qu'une demi rotation de précession dans son plan.

A la lecture, un courant de mesure (81) de faible amplitude est injecté dans la MTJ (60) et la valeur de sa résistance est lue par comparaison à une cellule de référence, qui n'est pas décrite sur la figure 3, comme dans l'état antérieur de la technique. Ici encore la nature spécifique des propriétés électroniques des AAF est mise à profit : Pour les mêmes raisons que discuté précédemment, la diffusion des électrons injectés par le courant de lecture (81) est très majoritairement liée au sous réseau des atomes de transition (72), permettant de différencier l'état du point mémoire (60) selon que l'aimantation du sous réseau (72) pointe dans une direction ou dans la direction opposée. Par ailleurs, la forte résistance électrique de la couche (63), liée à sa nature amorphe, n'est pas un obstacle dans la géométrie utilisée, puisqu'il est connu de l'homme de métier que la magnétorésistance tunnel est essentiellement liée aux interfaces des couches magnétiques (61) et (63) avec la couche isolante (62), donc aux quelques plans atomiques de part et d'autre des dites interfaces.

On comprend ainsi tout l'intérêt de l'invention, puisque le système obtenu permet l'écriture par un courant polarisé en spin tout en conservant une aimantation macroscopique faible, donc une valeur absolue dudit courant d'écriture réduite. La valeur de ladite aimantation macroscopique pouvant être contrôlée facilement par la nature chimique et/ou la composition des alliages AAF utilisés, le courant d'écriture peut être ajusté à volonté. En particulier, il peut être choisi tel que la tension aux bornes de la MTJ ne dépasse pas une valeur critique préalablement déterminée.

Avantageusement, la forte résistivité des AAF peut être mise à profit pour réduire encore le courant d'écriture en utilisant le chauffage local induit par la conjonction du courant d'écriture et de la dite forte résistivité. Si l'AAF a été judicieusement choisi, un tel chauffage permet de réduire localement la contribution relative du sous réseau de terre rare (71) par rapport au sous réseau de métal de transition (72), d'une part, et de diminuer le champ de retournement dudit sous réseau de métal de transition, d'autre part.

Avantageusement la couche magnétique (61) peut être choisie en alliage AAF, préférentiellement en alliage AAF de fort champ de retournement pour s'affranchir de la nécessité de la couche de piégeage (69). De façon préférentielle mais non limitative la couche (61) peut être formée d'un alliage de terbium et de cobalt, ou d'un alliage de samarium et de cobalt.

On conçoit dès lors, que par la mise en oeuvre d'AAF présentant un faible moment magnétique à la température de fonctionnement de la mémoire, que l'on peut contrôler à volonté en jouant sur la concentration des constituants respectifs dudit AAF et sur la température de fonctionnement du point mémoire, il devient possible de diminuer de manière significative la densité de courant appliquée lors de l'écriture sans risque de claquage de la jonction tunnel magnétique. De fait, on peut utiliser l'écriture par courant polarisé en spin et bénéficier des avantages qui y sont associés :

- suppression de l'une des lignes de courant, et corollairement positionnement du transistor de sélection sous le point mémoire, aboutissant à un degré d'intégration accru.
- adressage individuel desdits points mémoire, supprimant tout risque d'erreur d'adressage, ce que l'on ne pouvait faire avec la technologie standards de conducteurs croisés.

De plus, la mise en oeuvre d'une couche libre à aimantation planaire, c'est à dire dans le plan de la couche, permet de réduire la durée du pulse pour l'écriture, optimisant de la sorte la rapidité d'écriture de ce type de mémoire.

## Revendications

1. Procédé d'écriture dans une mémoire magnétique dont chaque point mémoire est constitué d'une jonction tunnel magnétique (60), comprenant :

   une couche magnétique piégée (61) dont l'aimantation est rigide ;
   une couche magnétique libre (63) dont l'aimantation est susceptible d'être inversée ;
   une couche isolante (62), interposée entre la couche libre (63) et la couche piégée (61) et au contact respectif de la couche libre et de la couche piégée,

   chaque point mémoire étant en contact sur une de ses faces avec un conducteur électrique (67), consistant à injecter dans un point mémoire à écrire un courant électrique dans ledit conducteur correspondant, la couche piégée dudit point mémoire assurant la polarisation en spin du courant électrique, **caractérisé en ce qu'**il consiste :

   à prévoir, pour chaque point mémoire, la couche libre (63) en un alliage amorphe ou nanocristallisé à base de terre rare et d'un métal de transition, l'ordre magnétique dudit alliage étant de type ferrimagnétique, ladite couche libre (63) étant à aimantation sensiblement planaire.

2. Procédé selon la revendication 1, consistant, en outre, à chauffer ledit point mémoire, lors de l'injection du courant électrique pour diminuer l'amplitude du moment magnétique de la couche magnétique libre (63).

3. Procédé selon la revendication 1, consistant, en outre, à prévoir une couche de polarisation additionnelle (64), positionnée du côté de la couche libre (63) opposé à la couche piégée (61), et séparée de la couche libre par une couche métallique non magnétique (65), la couche de polarisation additionnelle participant à la polarisation en spin du courant électrique.

**4.** Mémoire magnétique comprenant des points mémoire, chaque point mémoire étant constitué d'une jonction tunnel magnétique (60), comprenant :

une couche magnétique piégée (61), dont l'aimantation est rigide ;
une couche magnétique libre (63), dont l'aimantation est susceptible d'être inversée ;
une couche isolante (62), interposée entre la couche libre (73) et la couche piégée (61) et au contact respectif de la couche libre (73) et de la couche piégée,

la mémoire comprenant un conducteur électrique (67) placé sur chacun des points mémoire, ledit conducteur étant adapté à injecter un courant électrique dans un point mémoire à écrire, ledit courant étant polarisé en spin par la couche piégée (61), **caractérisée en ce que** la couche libre (63) est réalisée en un alliage amorphe ou nanocristallisé à base de terre rare et d'un métal de transition, l'ordre magnétique dudit alliage étant de type ferrimagnétique, ladite couche libre (63) étant à aimantation sensiblement planaire.

**5.** Mémoire magnétique selon la revendication 4, **caractérisée en ce que** la couche libre (63) est réalisée à base d'un alliage de Gadolinium et de Cobalt.

**6.** Mémoire magnétique selon l'une des revendications 4 et 5, **caractérisée en ce que** la couche libre (63) intègre en outre en faible quantité un ou plusieurs éléments de substitution.

**7.** Mémoire magnétique selon la revendication 6, **caractérisée en ce que** les éléments de substitution sont choisis dans le groupe comprenant le Zr, Mo, Nb, Ta, Pt, Dy et Sm.

**8.** Mémoire magnétique selon l'une des revendications 4 à 7, **caractérisée en ce que** la couche piégée (61) est réalisée en un alliage amorphe à base de terre rare et d'un métal de transition, l'ordre magnétique dans ledit alliage étant de type ferrimagnétique.

**9.** Mémoire magnétique selon la revendication 8, **caractérisée en ce que** la couche piégée (61) est réalisée en un alliage amorphe à base de Terbium et de Cobalt.

**10.** Mémoire magnétique selon l'une des revendications 4 à 7, **caractérisée en ce que** la couche piégée (61) est réalisée en un alliage amorphe à base de terre rare et d'un métal de transition, l'ordre magnétique dans ledit alliage étant de type ferromagnétique.

**11.** Mémoire magnétique selon la revendication 10, **caractérisée en ce que** la couche piégée (61) est réalisée en un alliage amorphe à base de Samarium et de Cobalt.

**12.** Mémoire magnétique selon l'une des revendications 4 à 11, **caractérisée en ce que** chaque point mémoire comporte en outre une couche ferromagnétique de polarisation additionnelle (64), positionnée du côté de la couche libre (63) opposé à la couche piégée (61), et séparée de la couche libre par une couche métallique non magnétique (65), ladite couche de polarisation additionnelle (64) étant adaptée à polariser en spin le courant électrique injecté dans le point mémoire.

**13.** Mémoire magnétique selon la revendication 12, **caractérisée en ce que** la couche de polarisation additionnelle (64) possède une aimantation perpendiculaire au plan des couches constitutives de la jonction tunnel magnétique (60).

**14.** Mémoire magnétique selon la revendication 12, **caractérisée en ce que** la couche de polarisation additionnelle (64) possède une aimantation parallèle au plan des couches constitutives de la jonction tunnel magnétique (60).

**15.** Mémoire magnétique selon l'une des revendications 12 à 14, **caractérisée en ce que** la couche de polarisation additionnelle (64) est formée d'un alliage de Terbium et de Cobalt.

**Claims**

**1.** A method for writing into a magnetic memory, each memory point of which is formed of a magnetic tunnel junction (60), comprising:

a locked magnetic layer (61) having a rigid magnetization,
a free magnetic layer (63) having a magnetization that can be inverted,
an insulating layer (62), interposed between the free layer (63) and the locked layer (61), and respectively in contact with the free layer and with the locked layer,

each memory point being in contact on one of its surfaces with an electric conductor (67),
consisting of injecting at the level of a memory point to be written an electric current into said corresponding conductor, the locked layer of said memory point ensuring the spin polarization of the electric current, **characterized in that** it consists of:

> providing, for each memory point, the free layer (63) in an amorphous or nanocrystallized alloy based on a rare earth and a transition metal, the magnetic order of said alloy being of ferrimagnetic type, said free layer (63) having a substantially planar magnetization.

2. The method of claim 1, further comprising heating said memory point during the injection of an electric current to decrease the magnitude of the magnetic moment of the free magnetic layer (63).

3. The method of claim 1, further comprising providing an additional polarizing layer (64), positioned on the side of the free layer (63) opposite to the locked layer (61), and separated from the free layer by a non-magnetic metal layer (65), the additional polarizing layer participating to the spin polarization of the electric current.

4. A magnetic memory having memory points, each memory point being formed of a magnetic tunnel junction (60), comprising:

> a locked magnetic layer (61) having a rigid magnetization,
> a free magnetic layer (63) having a magnetization that can be inverted,
> an insulating layer (62), interposed between the free layer (63) and the locked layer (61) and respectively in contact with the free layer (63) and with the locked layer,

the memory comprising an electric conductor (67) disposed on each memory point, said conductor being adapted to inject an electric current in a memory point to be written, said current being spin polarized by the locked layer (61), **characterized in that** the free layer (63) is made of an amorphous or nanocrystallized alloy based on a rare earth and a transition metal, the magnetic order of said alloy being of ferrimagnetic type, said free layer (63) having a substantially planar magnetization.

5. The magnetic memory of claim 4, **characterized in that** the free layer (63) is made of a gadolinium and cobalt alloy.

6. The magnetic memory of claim 4 and 5, **characterized in that** the free layer (63) further contains a low quantity of one or several substitution elements.

7. The magnetic memory of claim 6, **characterized in that** the substitution elements are selected from the group comprising Zr, Mo, Nb, Ta, Pt, Dy, Sm.

8. The magnetic memory of any of claims 4 to 7, **characterized in that** the locked layer (61) is made of an amorphous alloy based on a rare earth and a transition metal, the magnetic order in said alloy being of ferrimagnetic type.

9. The magnetic memory of claim 8, **characterized in that** the locked layer (61) is made of a terbium and cobalt based amorphous alloy.

10. The magnetic memory of any of claims 4 to 7, **characterized in that** the locked layer (61) is made of an amorphous alloy based on a rare earth and a transition metal, the magnetic order in said alloy being of ferromagnetic type.

11. The magnetic memory of claim 10, **characterized in that** the locked layer (61) is made of a samarium and cobalt alloy.

12. The magnetic memory of any of claims 4 to 11, **characterized in that** each memory point further comprises an additional polarizing ferromagnetic layer (64), positioned on the side of the free layer (63) opposite to the locked layer (61), and separated from the free layer by a non-magnetic metal layer (65), said additional polarizing layer (64) being adapted to spin polarize the electric current injected into the memory point.

13. The magnetic memory of claim 12, **characterized in that** the additional polarizing layer (64) has a magnetization perpendicular to the plane of the layers forming the magnetic tunnel junction (60).

14. The magnetic memory of claim 12, **characterized in that** the additional polarizing layer (64) has a magnetization parallel to the plane of the layers forming the magnetic tunnel junction (60).

15. The magnetic memory of any of claims 12 to 14, **characterized in that** the additional polarizing layer (64) is made of a terbium and cobalt alloy.

**Patentansprüche**

1. Verfahren zum Beschreiben eines Magnetspeichers, wobei jeder Speicherpunkt des Magnetspeichers durch einen magnetischen Tunnelübergang (60) gebildet ist, mit folgenden Merkmalen:

> eine verriegelte Magnetschicht (61) mit einer starren Magnetisierung,
> eine freie Magnetschicht (63) mit einer Magnetisierung, die invertiert werden kann,

eine Isolationsschicht (62), die zwischen der freien Schicht (63) und der verriegelten Schicht (61) liegt und jeweils in Kontakt mit der freien Schicht und der verriegelten Schicht ist,

wobei jeder Speicherpunkt auf einer seiner Oberflächen mit einem elektrischen Leiter (67) in Kontakt ist, wobei das Verfahren auf dem Niveau eines Speicherpunktes, der beschrieben werden soll, einen elektrischen Strom in den entsprechenden Leiter einspeist, wobei die verriegelte Schicht des Speicherpunktes eine Spin-Polarisierung des elektrischen Stroms gewährleistet,
**gekennzeichnet durch**:
Vorsehen einer freien Schicht (63) in einer amorphen oder nanokristallinen Legierung gestützt auf eine Seltenerde und ein Ubergangsmetall für jeden Speicherpunkt, wobei die magnetische Ordnung der Legierung ferrimagnetisch ist und wobei die freie Schicht (63) eine im wesentlichen planare Magnetisierung aufweist

2. Verfahren nach Anspruch 1, bei dem der Speicherpunkt während des Einspeisens eines elektrischen Stroms erhitzt wird, um die Größe des magnetischen Moments der freien Magnetschicht (63) zu verringern

3. Verfahren nach Anspruch 1, bei dem eine zusätzliche Polarisationsschicht (64) vorgesehen wird, die auf der Seite der freien Schicht (63) der verriegelten Schicht (61) gegenüber positioniert wird und von der freien Schicht durch eine nicht-magnetische Metallschicht (65) getrennt wird, wobei die zusätzliche Polarisationsschicht an der Spin-Polarisation des elektrischen Stroms teilnimmt.

4. Magnetspeicher mit Magnetpunkten, wobei jeder Magnetpunkt durch einen magnetischen Tunnelübergang (60) gebildet ist, mit:

einer verriegelten Magnetschicht (61) mit einer starren Magnetisierung;
einer freien Magnetschicht (63) mit einer Magnetisierung, die invertiert werden kann;
einer Isolationsschicht (62), die zwischen der freien Schicht (63) und der verriegelten Schicht (61) liegt und jeweils in Kontakt mit der freien Schicht (63) und der verriegelten Schicht ist,

wobei der Speicher einen elektrischen Leiter (67) aufweist, der auf jedem Speicherpunkt angeordnet ist, wobei der Leiter einen elektrischen Strom in einen zu beschreibenden Speicherpunkt einspeisen kann, wobei der Strom durch die verriegelte Schicht (61) spinpolarisiert wird,
**dadurch gekennzeichnet, daß** die freie Schicht (63) auf einer amorphen oder nanokilstallinen Legierung basierend auf einer Seltenerd und einem Ubergangsmetall hergestellt ist,
wobei die magnetische Ordnung der Legierung ferrimagnetisch ist und die freie Schicht (63) eine im wesentlichen planare Magnetisierung aufweist

5. Magnetspeicher nach Anspruch 4, **dadurch gekennzeichnet, daß** die freie Schicht (63) aus einer Gadolinium- und Kobaltlegierung hergestellt ist

6. Magnetspeicher nach Anspruch 4 und 5, **dadurch gekennzeichnet, daß** die freie Schicht (63) ferner eine geringe Menge eines oder mehrere Ersatzelemente aufweist.

7. Magnetspeicher nach Anspruch 6, **dadurch gekennzeichnet, daß** die Ersatzelemente aus der Gruppe ausgewählt sind, welche umfaßt Zr, Mo, Nb, Ta, Pt, Dy, Sm

8. Magnetspeicher nach einem der Ansprüche 4 bis 7, **dadurch gekennzeichnet, daß** die verriegelte Schicht (61) aus einer amorphen Legierung basierend auf einer Seltenerde und einem Übergangsmetall hergestellt ist, wobei die magnetische Ordnung der Legierung ferrimagnetisch ist

9. Magnetspeicher nach Anspruch 8, **dadurch gekennzeichnet, daß** die verriegelte Schicht (61) aus einer amorphen Legierung auf der Basis von Terbium und Kobalt hergestellt ist.

10. Magnetspeicher nach einem der Ansprüche 4 bis 7, **dadurch gekennzeichnet, daß** die verriegelte Schicht (61) aus einer amorphen Legierung basierend auf einer Seltenerde und einem Übergangsmetall hergestellt ist, wobei die magnetische Ordnung der Legierung ferromagnetisch ist

11. Magnetspeicher nach Anspruch 10, **dadurch gekennzeichnet, daß** die verriegelte Schicht (61) aus einer Samarium- und Kobaltlegierung hergestellt ist

12. Magnetspeicher nach einem der Ansprüche 4 bis 11, **dadurch gekennzeichnet, daß** jeder Speicherpunkt ferner eine zusätzliche ferromagnetische Polarisationsschicht (64) aufweist, die auf der Seite der freien Schicht (63), der verriegelten Schicht (61) gegenüber angeordnet und von der freien Schicht durch eine nicht-magnetische Metallschicht (65) getrennt ist, wobei die zusätzliche Polarisationsschicht (64) dazu geeignet ist, dem elektrischen Strom, der in den Speicherpunkt eingespeist wird, eine Spin-Polarisation zu verleihen

13. Magnetspeicher nach Anspruch 12, **dadurch gekennzeichnet, daß** die zusätzliche Polarisationsschicht (64) eine Magnetisierung aufweist, die senkrecht zu der Ebene der Schichten, welche den magnetischen Iunnelübergang (60) bilden, ist.

14. Magnetspeicher nach Anspruch 12, **dadurch gekennzeichnet, daß** die zusätzliche Polarisationsschicht (64) eine Magnetisierung aufweist, die parallel zu der Ebene der Schichten, welche den magnetischen Tunnelübergang (60) bilden, ist.

15. Magnetspeicher nach einem der Ansprüche 12 bis 14, **dadurch gekennzeichnet, daß** die zusätzliche Polarisationsschicht (64) aus einer Terbium- und Kobaltlegierung hergestellt ist.

FIGURE 1

EP 1 430 484 B1

FIGURE 2

FIGURE 3a

Aimantation

Température

FIGURE 3b

FIGURE 4a

FIGURE 4b

FIGURE 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4949039 A
- US 5159513 A
- US 5343422 A
- US 5640343 A
- US 6021065 A
- US 5583725 A
- US 5695864 A
- EP 1115164 A

**Littérature non-brevet citée dans la description**

- *Physics Letters,* 1975, vol. 54A, 225
- *Journal of Magnetism and Magnetic Materials,* 1995, vol. 139, L139
- *Physical Review Letters,* 1995, vol. 74, 3273
- *Journal of Applied Physics,* 1997, vol. 81, 3758
- *Journal of Magnetism and Magnetic Materials,* 1996, vol. 159, L1
- *Science,* 1999, vol. 285, 867
- Magnetic properties and microstructure of amorphous C0100-XTBX thinflims. **KUO P.C et al.** Journal of Applied Physics. American Institute of Physics, 15 Septembre 1998, vol. 84, 3317-3321